# EUROPEAN PATENT APPLICATION

(11) **EP 3 029 548 A1**
(43) Date of publication of application: **08.06.2016**
(21) Application number: 15196398.0
(22) Date of filing: 26.11.2015
(51) Int. Cl.: G06F 3/01, G01R 33/02, G01B 7/004, G01V 3/12, G01R 33/00

(54) **MOTION TRACKING SYSTEM USING ONE OR MORE MAGNETIC FIELDS**

(30) Priority: 03.12.2014 US 201414559459
(71) Applicant: Honeywell International Inc., Morris Plains, NJ 07950 (US)
(72) Inventor: LI, Xiahong Linda, Morris Plains, NJ New Jersey 07950 (US); PANT, Bharat B., Morris Plains, NJ New Jersey 07950 (US); LEIPHON, Ken, Morris Plains, NJ New Jersey 07950 (US); LEWANDOWSKI, Ronald, Morris Plains, NJ New Jersey 07950 (US); HERICKS, John Norbert, Morris Plains, NJ New Jersey 07950 (US)
(74) Representative: Houghton, Mark Phillip

(57) **Abstract**

A system for tracking motion of an object comprises at least a first magnetic source configured to generate a static magnetic field, with the magnetic source fixed in a first coordinate frame, and a plurality of magnetic sensors configured to be located on the object and to detect the static magnetic field. The magnetic sensors are located in a second coordinate frame that is movable relative to the first coordinate frame. A processor is operative to receive magnetic field data from the magnetic sensors. A memory unit coupled to the processor stores a magnetic field model or a magnetic field database defined for the first coordinate frame, and a magnetic sensor measurement model with uncertainties defined for the second coordinate frame. The processor computes and outputs an estimated position and orientation of the object based on the magnetic field data and other information stored in the memory unit.

## Description

### BACKGROUND

Current methods to track the position and orientation of a person's head or other object are complex and expensive. Existing magnetic head tracking or motion tracking systems require active transmission of magnetic fields. The magnetic transmitter is typically three coils of wire energized with electric current to produce a magnetic field. This requires cabling and complex drive circuitry. The three coils are energized one at a time successively or with three different frequencies.

Attempts have been made to use just the earth's magnetic field and a magnetometer to track a person's head, but this has severe limitations since it is not possible to get all three rotations (azimuth, elevation, and roll) from the Earth's magnetic field vector alone.

Accordingly, there is a need for simpler and less costly tracking systems for both commercial and military applications.

### SUMMARY

A system and method for tracking motion of an object is provided. The system comprises at least a first magnetic source configured to generate a first static magnetic field, with the first magnetic source fixed in a first coordinate frame, and a plurality of magnetic sensors configured to be located on the object and to detect the first static magnetic field. The magnetic sensors are located in a second coordinate frame that is movable relative to the first coordinate frame. A processor is operative to receive magnetic field data from the magnetic sensors. A memory unit operatively coupled to the processor is configured to store a magnetic field model or a magnetic field database defined for the first coordinate frame, and a magnetic sensor measurement model with uncertainties defined for the second coordinate frame. The processor computes and outputs an estimated position and orientation of the object based on the magnetic field data and other information stored in the memory unit.

### BRIEF DESCRIPTION OF THE DRAWINGS

Features of the present invention will become apparent to those skilled in the art from the following description with reference to the drawings. Understanding that the drawings depict only typical embodiments and are not therefore to be considered limiting in scope, the invention will be described with additional specificity and detail through the use of the accompanying drawings, in which:
Figure 1is a schematic diagram illustrating a motion tracking system according to one embodiment;
Figure 2 is a block diagram of a setup method for a motion tracking system according to one embodiment;
Figure 3 is a flow diagram for an estimation process used in a motion tracking system according to one embodiment;
Figures 4A-4C are schematic diagrams illustrating an exemplary setup for a motion tracking system according to one embodiment; and
Figure 5 is a schematic diagram illustrating an exemplary setup for a motion tracking system according to another embodiment.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

A motion tracking system and method are provided that employ one or more magnetic fieldsto track the position and orientation of a person's head or other object. In the present system and method, one or more static magnetic fields are generated from a magnetic source, such as one or more permanent magnets, or coils of wire driven with direct current (DC).

The magnetic source generates dipole fields with different axes of orientation, which are typically 90 degrees apart. The intersection of the dipole fields creates a unique set of field gradients. The DC magnetic fields are sensed with multiple three-axis magnetic sensors such as three receiver triads comprising non-collinear receivers. The receivers can be magnetoresistive magnetometers, or any other type of receiver capable of accurately measuring DC magnetic fields. The geometric location of receivers can be eitherfixed or variable with respect to one another.

In one embodiment, the present system employs two or more dipoles that generate DC magnetic fields, which are sensed by three or more receiver triads capable of sensing DC magnetic fields. The receiver triads can be mounted on a head mounted display, helmet, or head band, for example.

As the multiple receiver triads move within the DC magnetic fields, unique field gradients are sensed and can be analyzed to determine the x,y, and z positions of each sensor triad. Once the position of each receiver triad is known, the angular orientation of a sensor suite of the tracking system can be determined, including azimuth, elevation, and roll.In one embodiment, this allows the tracking system to determine both the location and orientation of a person's head or other object.

The simplicity of the present tracking system results in lower cost and allows the system to be used in environments that are largely impractical for other systems where significant metal is present, which can affect AC magnetic or pulsed-DC magnetic systems. Accordingly, the present system can be implemented in aircraft, tanks, armored vehicles, consumer wearable displays, motion pointing for wheelchair bound users,as well as other commercial or military applications.

The present system also does not have the weaknesses that optical trackers have as it is impervious to interference with light sources. In addition, the present approach avoids the eddy current issues of prior AC or pulsed DC systems in environments where metal is present.

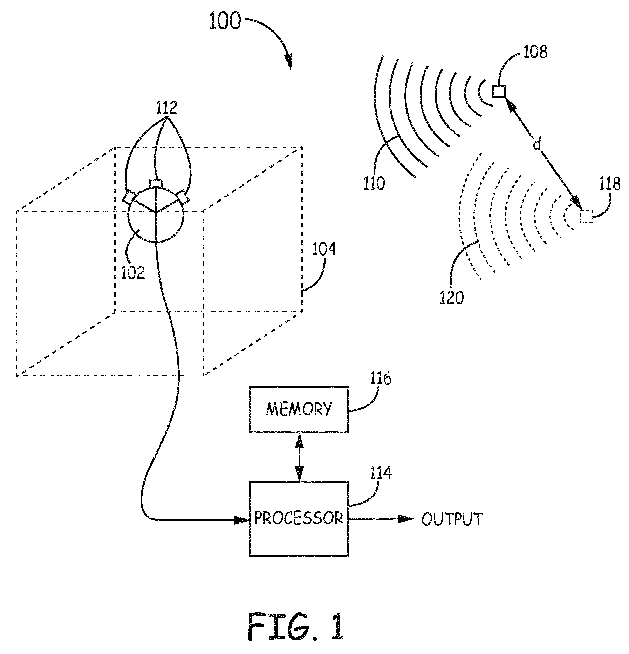

Figure 1 illustrates a motion tracking system 100 according to one embodiment. The tracking system 100 is configured to track an object 102 within a volume of interest 104 where magnetic distortion may be present, such as in the cockpit of an aircraft, for example. The tracking system 100 includes a first magnetic source 108 configured to generate a first static magnetic field 110, such as from a permanent magnet or a DC electromagnet. A plurality of magnetic sensors 112, such as receiver triads,are located on object 102 and configured to detect static magnetic field 110. As described further hereafter, magnetic source 108 is fixed in a first coordinate frame, and magnetic sensors 112are located in a second coordinate frame that is movable relative to the first coordinate frame when object 102 moves.The geometric location of magnetic sensors 112 on an object can be either fixed or variable with respect to each other.

A processor unit 114 is configured to receive magnetic field data from magnetic sensors 112 and is in operative communication with a memory unit 116.The processor unit 114 computes and outputs an estimated position and orientation of object 102 based on magnetic field data from magnetic sensors 112and other information stored in memory unit 116.

Figure 1 also illustrates an additional embodiment, in which two magnetic sources are employed. Accordingly, a second magnetic source 118, which is configured to generate a second static magnetic field 120, is positioned a fixed distance (*d*) apart from first magnetic source 108. The magnetic sources 108 and 118 are configured to generate dipole fields with different axes of orientation. The magnetic sources 108 and 118 allow system 100 to track the motion of object 102 in up to six degrees of freedom.

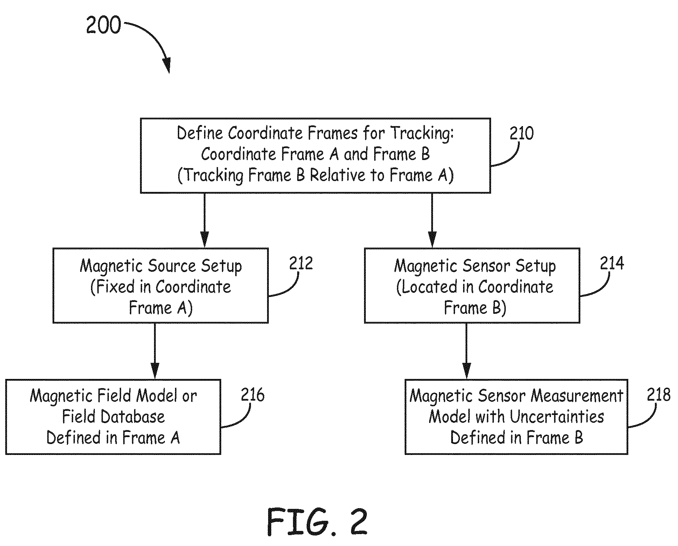

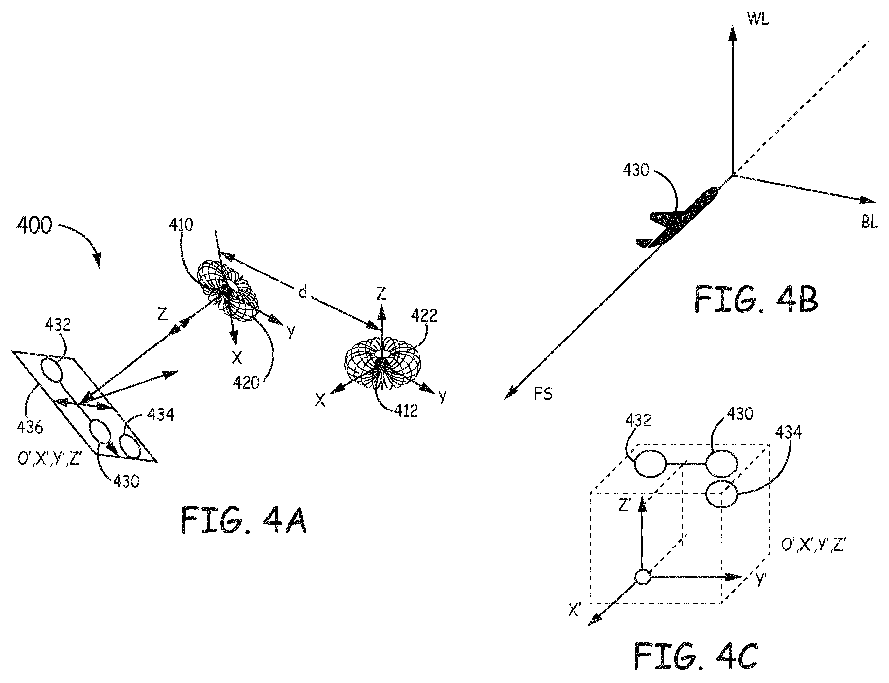

Figure 2 is a functional block diagram of a setup method 200 for the magnetic source, magnetic sensors, and coordinatesof the motion tracking system. Initially, the coordinate frames for tracking are defined, such as coordinate frame A and coordinate frame B (tracking frame B relative to frame A) (block 210). At least one magnetic source, fixed in coordinate frame A, is then setup (block 212). The magnetic sensors, located in coordinate frame B, are also setup (block 214). For example, in a pilot head tracking system for an aircraft, an aircraft FSBLWL frame (see Figure 4B) corresponds to coordinate frame A, and an O'X'Y'Z' sensor coordinate (see Figure 4C) corresponds to coordinate frame B.A magnetic field model or magnetic field database is then defined in coordinate frame A (block 216). A magnetic sensor measurement model with uncertainties is defined in coordinate frame B (block 218).

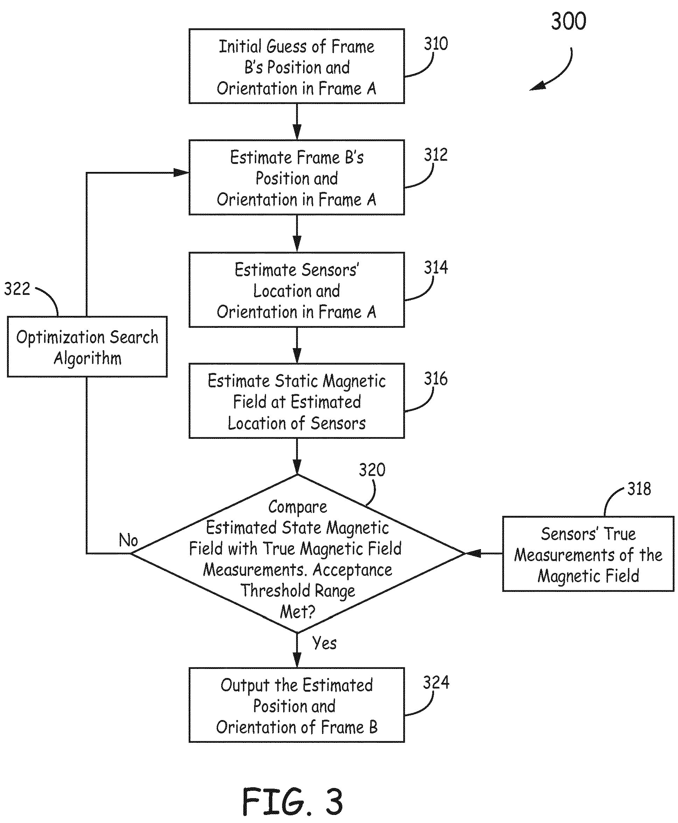

Figure 3 is a flow diagram for an estimation process 300 used in the present motion tracking system. An initial guess of the position and orientation of frame B in frame A is made (block 310). An estimate of the position and orientation of frame B in frame A is then computed (block 312). An estimate of the location and orientation of the sensors in frame A is thencomputed (block 314). An estimate of the static magnetic field at the estimated location of sensors in frame A is then determined (block 316). The sensors' true measurements of the static magnetic field are also obtained (block 318). A comparison of the estimated static magnetic field is made with the sensors' true measurements of the static magnetic field to determine whether the estimated static magnetic field is within an acceptance threshold range (block 320).

If the estimated static magnetic field is not acceptable, a standard optimization search algorithm is run (block 322), and method 300 repeats by returning to block 312 to again estimate the position and orientation of frame B in frame A. An example of an optimization search algorithm is the Levenberg-Marquardt technique, as will be evident to one of ordinary skillin the art. If the estimated static magnetic field is acceptable at block 320, an estimated position and orientation of frame B is output (block 324).

Figures 4A-4C illustrate an exemplary setup for a motion tracking system400 according to one embodiment. As shown in Figure 4A, a pair of magnetic dipoles 410 and 412 is installed at a fixed distance (*d*) apart from each other, such as in the cockpit of an aircraft in front of where a pilot would be seated. The magnetic dipole 410 is configured to generate a first static magnetic field 420, and the magnetic dipole 412 is configured to generate a second static magnetic field 422. A plurality of magnetic sensors 430, 432, and 434 are located on an object 436 such as the head of a pilot, and are configured to detect static magnetic fields420 and 422.

The magnetic dipoles 410 and 412 can be positioned in an FS-BL-WL (XYZ) coordinate for an aircraft 430 such as depicted in Figure 4B.In one embodiment, magnetic dipoles 410 and 412 are located at a fixed distance from each other along the aircraft BL axis. In this embodiment, magnetic dipole 410 has its magnetic z-axis aligned with the aircraft FS axis, and magnetic dipole 412 has its magnetic z-axis aligned with the aircraft WL axis.The magnetic sensors 430, 432, and 434 are located in a sensor coordinateO'X'Y'Z' (e.g., a pilot's head), such as shown in Figure 4C.

When system 400 is implemented for pilot head tracking, the pilot's head is free to move with up to six degrees of freedom, which is defined in the coordinates of magnetic dipole 410. This allows the position and orientation of the pilot's head to be measuredin up to six degrees of freedom.

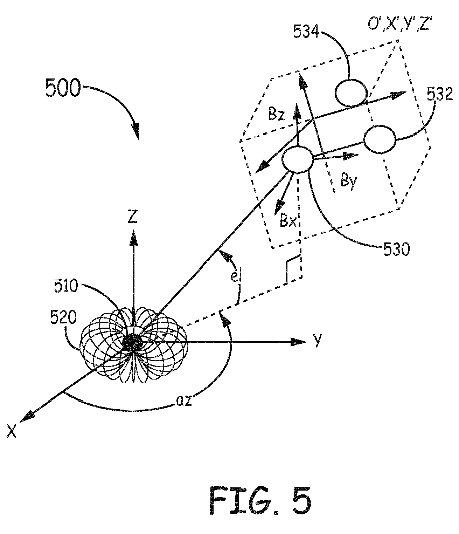

Figure 5 illustrates an exemplary setup for a motion tracking system 500 according to another embodiment. A magnetic dipole 510 is configured to generate a static magnetic field 520. A plurality of magnetic sensors 530, 532, and 534 are located on an object,such as a pilot's head, and are configured to detect static magnetic field 520. The magnetic dipole 510 is positioned in a magnetic field coordinateOXYZsuch as an airframe coordinate. A sensor coordinate O'X'Y'Z'is defined such as a head sensor coordinate. The magnetic sensors 530, 532, and 534 are located in the sensor coordinate O'X'Y'Z'.

During operation of motion tracking system 500, sensor coordinate O'X'Y'Z' moves and rotates in the magnetic field coordinate OXYZ space. The location of the sensor coordinate is defined by the position (XYZ) of its origin O' in the coordinate OXYZ. The rotational angles (attitudes) of the sensor coordinate are defined by Euler angles (phi, theta, psi) referred about the coordinateOXYZ.The positions of the sensors in the coordinateOXYZcan be derived from their locations in the sensor coordinate O'X'Y'Z, the position (XYZ) of origin O', and Euler angles. The locations of the sensors can be further defined by the elevation angle (el) and azimuth angle (az). The sensed magnetic field is VxVyVz (defined in the sensor coordinate O'X'Y'Z) and can be transferred into BxByBz (which is defined in the coordinateOXYZ) using Euler angles.In this configuration, the position and orientation of an object such as a pilot's head can be measured in up to five degrees of freedom.

A computer or processor used in the present methods and systems can be implemented using software, firmware, hardware, or any appropriate combination thereof, as known to one of skill in the art. These may be supplemented by, or incorporated in, specially-designed application-specific integrated circuits (ASICs) or field programmable gate arrays (FPGAs). The computer or processor can also include functions with software programs, firmware, or other computer readable instructions for carrying out various process tasks, calculations, and control functions used in the present method and system.

The present methods can be implemented by computer executable instructions, such as program modules or components, which are executed by at least one processor. Generally, program modules include routines, programs, objects, data components, data structures, algorithms, and the like, which perform particular tasks or implement particular abstract data types.

Instructions for carrying out the various process tasks, calculations, and generation of other data used in the operation of the methods described herein can be implemented in software, firmware, or other computer-or processor-readable instructions. These instructions are typically stored on any appropriate computer program product that includes a computer readable medium used for storage of computer readable instructions or data structures. Such a computer readable medium can be any available media that can be accessed by a general purpose or special purpose computer or processor, or any programmable logic device.

Suitable processor-readable media may include storage or memory media such as magnetic or optical media. For example, storage or memory media may include conventional hard disks, compact disks, DVDs, Blu-ray discs, or other optical storage disks; volatile or non-volatile media such as Random Access Memory (RAM); Read Only Memory (ROM), Electrically Erasable Programmable ROM (EEPROM), flash memory, and the like; or any other media that can be used to carry or store desired program code in the form of computer executable instructions or data structures.

### EXAMPLE EMBODIMENTS

Example 1 includes a system for tracking motion of an object, the system comprising: at least a first magnetic source configured to generate a first static magnetic field, the first magnetic source fixed in a first coordinate frame; a plurality of magnetic sensors configured to be located on the object and to detect the first static magnetic field, the magnetic sensors located in a second coordinate frame that is movable relative to the first coordinate frame; a processor operative to receive magnetic field data from the magnetic sensors; and a memory unit operatively coupled to the processor and configured to store a magnetic field model or a magnetic field database defined for the first coordinate frame, and a magnetic sensor measurement model with uncertainties defined for the second coordinate frame; wherein the processor computes and outputs an estimated position and orientation of the object based on the magnetic field data and other information stored in the memory unit.

Example 2 includes the system of Example 1, wherein the first magnetic source comprises a permanent magnet, or a direct current (DC) electromagnet.

Example 3 includes the system of any of Examples 1-2, wherein the magnetic sensors comprise three-axis magnetic receivers.

Example 4 includes the system of any of Examples 1-3, further comprising a second magnetic source positioned at a fixed distance from the first magnetic source in the first coordinate frame, the second magnetic source configured to generate a second static magnetic field.

Example 5 includes the system of Example 4, wherein the first and second magnetic sources are configured to generate DC magnetic fields having different axes of orientation.

Example 6 includes the system of Example 5, wherein the three-axis magnetic receivers are configured to detect the DC magnetic fields having different axes of orientation.

Example 7 includes the system of any of Examples3-6, wherein the three-axis magnetic receivers comprise magnetoresistive magnetometers.

Example 8 includes the system of any of Examples 3-7, wherein the estimated position and orientation of the object is computed for up to five degrees of freedom.

Example 9 includes the system of any of Examples 4-7, wherein the estimated position and orientation of the object is computed for up to six degrees of freedom.

Example 10 includes the system of any of Examples 1-9, wherein the first coordinate frame comprises an airframe coordinate, and the second coordinate frame comprises a head sensor coordinate.

Example 11 includes a method for tracking motion of an object, the method comprising: (a) defining a first coordinate frame for at least one magnetic source that generates a static magnetic field, and a second coordinate frame for a plurality of magnetic sensors; (b) estimating a position and orientation of the second coordinate frame with respect to the first coordinate frame; (c) estimating a location and orientation of the magnetic sensors in the first coordinate frame; (d) estimating a static magnetic field at the estimated location of the magnetic sensors; (e) obtaining actual measurements of the static magnetic field using the magnetic sensors; (f) comparing the estimated static magnetic field with the actual measurements of the static magnetic field to determine whether the estimated static magnetic field is within an acceptance threshold range; and (g) outputting an estimated position and orientation of the second coordinate frame when the estimated static magnetic field is within the acceptance threshold range.

Example 12 includes the method of Example 11, wherein when the estimated static magnetic field is not within the acceptance threshold range, the method further comprising: running an optimization search algorithm; and repeating the method starting at (b) until the estimated static magnetic field is within the acceptance threshold range.

Example 13 includes the method of any of Examples 11-12, wherein the at least one magnetic source comprises a permanent magnet, or a DC electromagnet.

Example 14 includes the method of any of Examples 11-13, wherein the estimated position and orientation of the second coordinate frame is computed for up to five degrees of freedom.

Example 15 includes the method of any of Examples 11-14, wherein the at least one magnetic source comprises a pair of magnetic sources positioned at a fixed distance from each other.

Example 16 includes the method of Example 15, wherein the estimated position and orientation of the second coordinate frame is computed for up to six degrees of freedom.

Example 17 includes the method of any of Examples 11-16, wherein the first coordinate frame comprises an airframe coordinate, and the second coordinate frame comprises a head sensor coordinate.

Example 18 includes a computer program product comprising: a computer readable medium having instructions stored thereon, executable by a processor, to perform a method for tracking motion of an object, the method comprising: (a)defining a first coordinate frame for at least one magnetic source that generates a static magnetic field, and a second coordinate frame for a plurality of magnetic sensors; (b)estimating a position and orientation of the second coordinate frame with respect to the first coordinate frame; (c)estimating a location and orientation of the magnetic sensors in the first coordinate frame; (d) estimating a static magnetic field at the estimated location of the magnetic sensors; (e) obtaining actual measurements of the static magnetic field using the magnetic sensors; and (f) comparing the estimated static magnetic field with the actual measurements of the static magnetic field to determine whether the estimated static magnetic field is within an acceptance threshold range, wherein: (i) when the estimated static magnetic field is not within the acceptance threshold range, running an optimization search algorithm and repeating the method starting at (b); (ii) when the estimated static magnetic field is within the acceptance threshold range, outputting an estimated position and orientation of the second coordinate frame.

Example 19 includes the computer program product of Example 18, wherein the estimated position and orientation of the second coordinate frame is determined for up to five degrees of freedom.

Example 20 includes the computer program product of Example 18, wherein the estimated position and orientation of the second coordinate frame is determined for up to six degrees of freedom when the at least one magnetic source comprises a pair of magnetic sources positioned at a fixed distance from each other.

The present invention may be embodied in other specific forms without departing from its essential characteristics. The described embodiments are to be considered in all respects only as illustrative and not restrictive. The scope of the invention is therefore indicated by the appended claims rather than by the foregoing description. All changes that come within the meaning and range of equivalency of the claims are to be embraced within their scope.

## Claims

1. A system for tracking motion of an object, the system comprising:
at least a first magnetic source configured to generate a first static magnetic field, the first magnetic source fixed in a first coordinate frame;
a plurality of magnetic sensors configured to be located on the object and to detect the first static magnetic field, the magnetic sensors located in a second coordinate frame that is movable relative to the first coordinate frame;
a processor operative to receive magnetic field data from the magnetic sensors; and
a memory unit operatively coupled to the processor and configured to store a magnetic field model or a magnetic field database defined for the first coordinate frame, and a magnetic sensor measurement model with uncertainties defined for the second coordinate frame;
wherein the processor computes and outputs an estimated position and orientation of the object based on the magnetic field data and other information stored in the memory unit.

2. The system of claim 1, wherein the first magnetic source comprises a permanent magnet, or a direct current (DC) electromagnet.

3. The system of claim 1, wherein the magnetic sensors comprise three-axis magnetic receivers.

4. The system of claim 3, further comprising a second magnetic source positioned at a fixed distance from the first magnetic sourcein the first coordinate frame, the second magnetic source configured to generate a second static magnetic field.

5. The system of claim 4, wherein the first and second magnetic sources are configured to generate DC magnetic fields having differentaxes of orientation.

6. The system of claim 5, wherein thethree-axis magnetic receivers are configured to detect the DC magnetic fields having differentaxes of orientation.

7. The system of claim 3, wherein the estimated position and orientation of the object is computed for up to five degrees of freedom.

8. The system of claim 4, wherein the estimated position and orientation of the object is computed for up to six degrees of freedom.

9. A method for tracking motion of an object, the method comprising:
(a) defining a first coordinate frame for at least one magnetic source that generates a static magnetic field, and a second coordinate frame for a plurality of magnetic sensors;
(b) estimating a position and orientation of the second coordinate frame with respect to the first coordinate frame;
(c) estimating a location and orientation of the magnetic sensors in the first coordinate frame;
(d) estimating a static magnetic field at the estimated location of the magnetic sensors;
(e) obtaining actual measurements of the static magnetic field using the magnetic sensors;
(f) comparing the estimatedstatic magnetic field with the actual measurements of the static magnetic field to determine whether the estimatedstatic magnetic field is within an acceptance threshold range; and
(g) outputting an estimated position and orientation of the second coordinate frame when the estimatedstatic magnetic field is within the acceptance threshold range.

10. The method of claim 9, wherein when the estimatedstatic magnetic field is not within the acceptance threshold range, the method further comprising:
running an optimization search algorithm; and
repeating the method starting at (b) until the estimatedstaticmagnetic field is within the acceptance threshold range.
